Europäisches Patentamt

European Patent Office

Office européen des brevets

(19)

(11) Veröffentlichungsnummer: **0 072 492**
**A2**

(12) **EUROPÄISCHE PATENTANMELDUNG**

(21) Anmeldenummer: 82107037.2

(22) Anmeldetag: 04.08.82

(51) Int. Cl.³: **H 01 L 23/56**
H 01 L 23/32, H 01 L 23/48

(30) Priorität: 14.08.81 US 293036

(43) Veröffentlichungstag der Anmeldung:
23.02.83 Patentblatt 83/8

(84) Benannte Vertragsstaaten:
DE FR GB

(71) Anmelder: Hewlett-Packard Company
Mail Stop 20 B-0 3000 Hanover Street
Palo Alto California 94043(US)

(72) Erfinder: Wright, Allen Joel
4190 NW Arrowood Cir
Corvallis Oregon 97330(US)

(74) Vertreter: Schulte, Knud, Dipl.-Ing.
c/o Hewlett-Packard GmbH Europ. Patent- und
Lizenzabteilung Postfach 1430 Herrenberger Strasse 130
D-7030 Böblingen(DE)

(54) **Integrierter Schaltungsmodul für ein elektronisches Gerät mit einer Steckeinrichtung.**

(57) Ein integrierter Schaltungsmodul enthält einen integrierten Schaltkreis, der innerhalb eines Behältnisses mit einem flexiblen Flachbandkabel bzw. einer flexiblen Schaltungsplatine verbunden ist. Durch Federkraft werden die Leiterbahnen der flexiblen Schaltungsplatine gegen eine leitfähige Fläche in dem Behältnis gedrückt, so daß die leiterbahnen kurzgeschlossen werden und das Potential aller Kontaktleitungen des integrierten Schaltkreises gleichmäßig bei einer elektrostatischen Entladung angehoben wird. Durch eine Öffnung in dem Behältnis kann eine Steckeinrichtung eingesetzt werden, um die Kurzschlußverbindung aufzutrennen und den integrierten Schaltkreis mit dem elektronischen Gerät zu verbinden. Der Schutz wird automatisch wiederhergestellt, wenn die Steckeinrichtung herausgezogen wird.

FIG 1

EP 0 072 492 A2

DEZEICHNUNG GEÄNDERT
siehe Titelseite

Hewlett-Packard Company

## INTEGRIERTER SCHALTUNGSMODUL

Die Erfindung betrifft einen integrierten Schaltungsmodul für ein elektronisches Gerät mit einer Steckeinrichtung für diesen gemäß dem Oberbegriff von Anspruch 1.

Viele elektronische Geräte, beispielsweise Rechner, können einen oder mehrere einsteckbare integrierte Schaltungsmodule aufnehmen, so daß die Flexibilität oder Kapazität des Gerätes erweitert wird.

Der Erfindung liegt die Aufgabe zugrunde, einen integrierten Schaltungsmodul der genannten Art derart zu verbessern, daß der integrierte Schaltkreis geschützt wird gegen elektrostatische Entladungen und durch diese hervorgerufene Spannungen an den Kontakten des Schaltkreises. Die Lösung dieser Aufgabe ist gekennzeichnet im Anspruch 1.

Gemäß bevorzugten Ausführungsformen widersteht ein integrierter Schaltungsmodul elektrostatischen Entladungen, indem das gleiche Potential an allen Kontaktleitungen aufrechterhalten wird, wenn der Schaltungsmodul von dem elektronischen Gerät abgeschaltet ist. Flexible Schaltungsverbindungen innerhalb des Moduls schließen elektrisch alle Kontaktleitungen mit einer leitfähigen Fläche kurz, so daß elektrostatische Entladungen bewirken, daß das Potential gleichförmig auf allen Leitungen ansteigt. Der Kontakt mit der leitfähigen Oberfläche erfolgt durch ein Federglied, so daß eine Steckeinrichtung in dem elektronischen Gerät eingesetzt werden kann und die Feder auslenkt, den Schaltkreis des Schaltungsmoduls von der leitfähigen Fläche trennt und gleichzeitig die gewünschten Verbindungen zu dem elektronischen Gerät herstellt. Wenn die Steckeinrichtung entfernt wird, stellt das Federglied den Schaltkreis wieder in dessen ursprüngliche Position zurück und stellt den Schutz gegen statische Entladungen wieder her.

Im folgenden werden bevorzugte Ausführungsbeispiele der Erfindung anhand der Zeichnungen erläutert; es zeigen:

Figur 1 in explodierter Darstellung einen integrierten Schaltungsmodul, der geschützt ist gegen Spannungsdifferenzen aufgrund elektrostatischer Entladungen,

Figur 2 eine Steckeinrichtung,

Figur 3a und 3b Querschnittsansichten eines integrierten Schaltungsmoduls, der gegen elektrostatische Entladungen geschützt ist, wenn dieser getrennt bzw. wenn dieser mit einer Steckeinrichtung verbunden ist,

Figur 4 eine Querschnittsansicht eines anderen integrierten Schaltungsmodules gemäß der Erfindung,

Figur 5 eine Querschnittsansicht eines weiteren integrierten Schaltungsmodules gemäß der Erfindung.

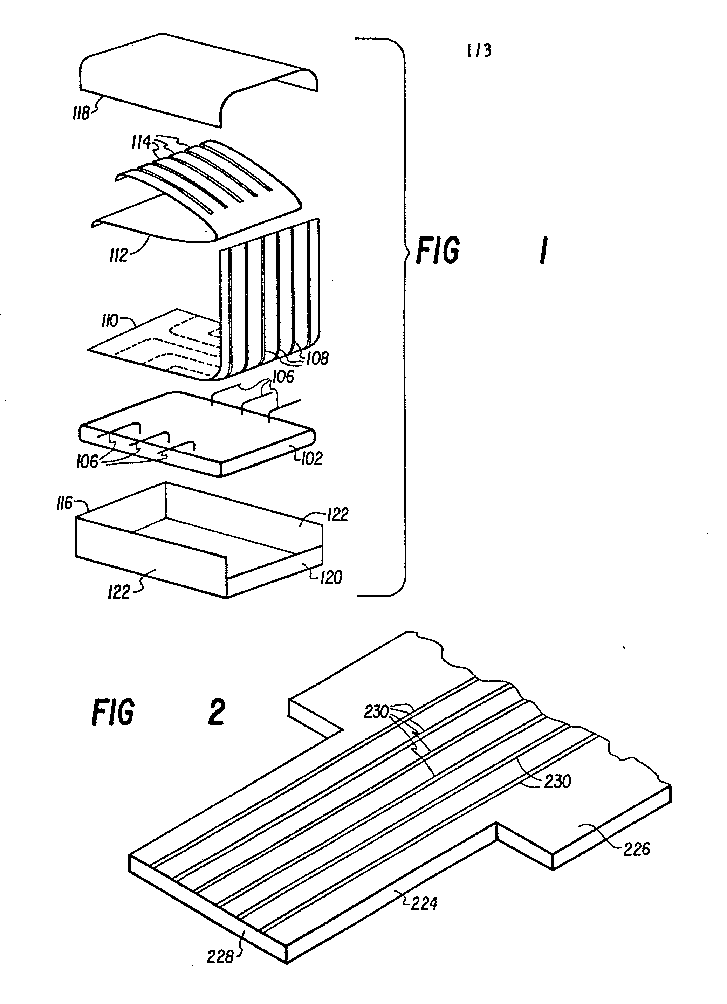

In Figur 1 ist ein integrierter Schaltkreis 102 dargestellt, der zusammen mit einem elektronischen Gerät mit einer Steckeinrichtung verwendet werden soll. Beispielsweise kann der integrierte Schaltkreis 102 ein Festwertspeicher oder ein Speicher mit wahlfreiem Zugriff sein, während das elektronische Gerät ein Rechner sein kann, der zur Aufnahme irgendeines dieser Speicher gemäß den auszuführenden Rechnungen geeignet ist.

Der integrierte Schaltkreis 102 hat Kontaktleitungen 106, deren Anzahl naturgemäß von der jeweiligen Anwendung abhängt. Bei den bevorzugten Ausführungsformen sind die Kontaktleitungen 106 an Leiterbahnen 108 eines Flachband-Mehrleiterkabels 110 gelötet.

Das Mehrleiterkabel 110 wird dann vorzugsweise um eine Feder 112 gewickelt, so daß die Leiterbahnen 108 sich nach außen erstrecken und sich nicht im Kontakt mit der Feder befinden. Es kann ein druckempfindlicher Klebstoff verwendet werden, um das Flachbandkabel bzw. die flexible Schaltungsplatine 110 an der Feder 112 zu befestigen. Bei den bevorzugten Ausführungsformen hat die Feder 112 getrennte Zinken 114, so daß Druck gegen die einzelnen Leiterbahnen 108 ausgeübt wird.

Bei den bevorzugten Ausführungsformen wird ein Behältnis durch einen Kasten 116 und einen Deckel 118 ausgebildet. Die integrierte Schaltung 102, das flexible Flachbandkabel 110 und die Feder 112 werden in den Kasten 116 eingebracht, und dann kann der Deckel 118 federnd aufgesetzt werden. Der Kasten 116 kann aus Kunststoffmaterial im Spritzgußverfahren hergestellt werden, während der Deckel 118 vorzugsweise aus Metall besteht. Es können auch andere Verfahren zum Herstellen von Behältnissen verwendet werden, solange eine leitfähige Oberfläche entsprechend der Innenfläche des Deckels 118 vorgesehen wird, um die Leiterbahnen 108 elektrisch kurzzuschließen. Beispielsweise kann das gesamte Behältnis aus Kunststoffmaterial mit einem eingelegten Metallband oder einer metallisch beschichteten Oberfläche bestehen, die auf der Innenseite des Kastens über den Leiterbahnen 108 angebracht ist.

Bei den bevorzugten Ausführungsformen hat der Kasten 116 eine Seite 120, welche niedriger als die angrenzenden Seiten 122 ist. Wenn der Deckel 118 über dem Kasten 116 angeordnet wird, läßt die verminderte Höhe der Seitenwand 120 gegenüber den Seitenwänden 122 eine Öffnung zwischen der Seitenwand 120 und dem Deckel 118 frei, durch welche eine Steckeinrichtung eingeschoben werden kann.

Figur 2 zeigt eine Steckeinrichtung 224, welche bei der Ausführungsform gemäß 1 verwendet werden kann. Der Abschnitt 226 ist zur Befestigung an einem elektronischen Gerät vorgesehen, welches für einen integrierten Schaltungsmodul ausgelegt ist, während das Ende 228 derart ausgebildet ist, daß es in den Modul eingesetzt wird. Die Steckeinrichtung 224 kann aus gewöhnlichem starren Material für Schaltungsplatinen hergestellt werden. Die Leiterbahnen 230 sind derart angeordnet, daß sie dem Abstand der Leiterbahnen 108 in Figur 1 entsprechen, so daß Verbindungen zwischen dem elektronischen Gerät und dem integrierten Schaltkreis hergestellt werden können.

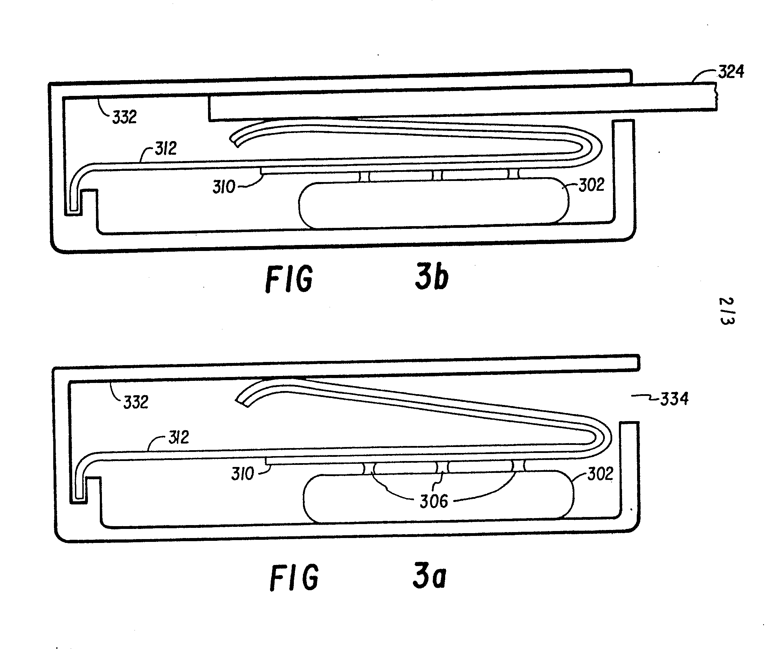

Der Betrieb des Schaltungsmodules gemäß den bevorzugten Ausführungsformen wird anhand von Figur 3a und 3b erläutert. Gemäß Figur 3a ist ein integrierter Schaltkreis 202 mit Leiterbahnen auf einem flexiblen Flachbandkabel 310 verbunden, welches gegen die leitfähige Fläche 332 durch eine Feder 312 gedrückt wird. Auf diese Weise werden Kontaktleitungen 306 elektrisch kurzgeschlossen, so daß irgendeine elektrostatische Entladung bewirkt, daß das Potential auf den Leitungen 306 gleichförmig ansteigt, wodurch Differenzspannungen und damit Schäden an dem integrierten Schaltkreis vermieden werden. Durch eine Öffnung 334 kann eine Steckeinrichtung derart eingesetzt werden, daß der integrierte Schaltkreis 302 mit einem elektronischen Gerät verbunden wird.

Gemäß Figur 3b wurde eine Steckeinrichtung 324 eingesetzt, welche die Feder 312 auslenkt. Der Kontakt zwischen dem flexiblen Flachbandkabel 310 und der leitfähigen Fläche 332 wird dadurch unterbrochen, während der Kontakt zwischen den Leiterbahnen auf der Unterseite der Steckeinrichtung 324 und den Leiterbahnen auf dem Flachbandkabel 310 hergestellt wird. Auf diese Weise kann eine Verbindung zwischen der integrierten Schaltung 302 und einem elektronischen Gerät hergestellt werden. Wenn die Steckeinrichtung 324 abgezogen wird, nimmt die Feder 312 die in Figur 3a dargestellte Gestalt an, und stellt den Schutz gegen elektrostatische Entladungen wieder her.

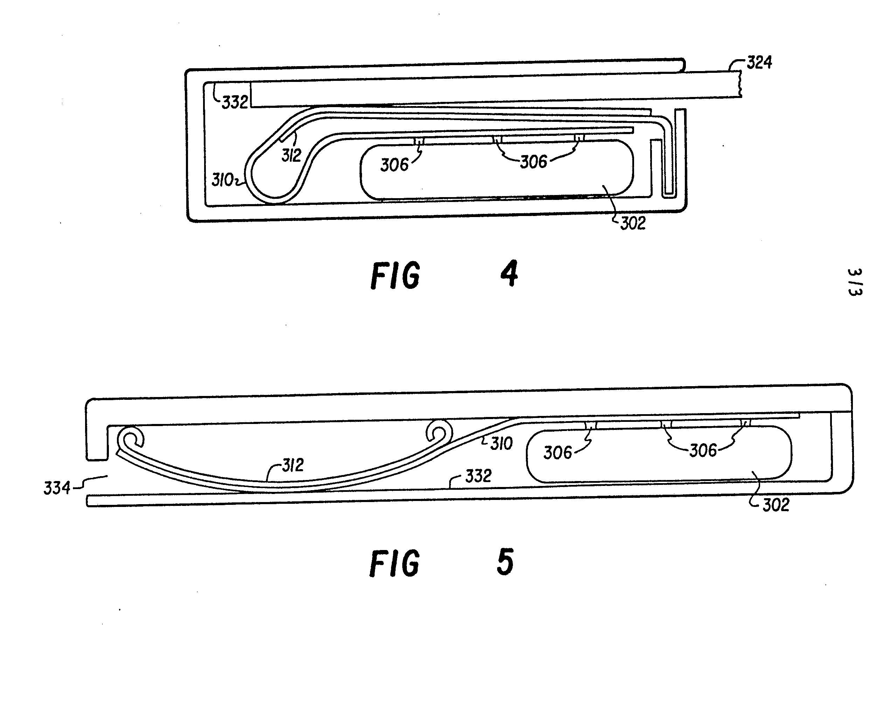

Figur 4 und 5 zeigen andere Ausführungsformen, welche zweckmäßig sind, wenn bei der Bemessung des Moduls bestimmte Vorgaben bezüglich der Größe und Gestalt einzuhalten sind. Bezugszeichen in diesen Figuren bezeichnen Gegenstände, welche denen mit gleichen Bezugszeichen in den Figuren 3a und 3b entsprechen. In Figur 4 ist das flexible Schmalbandkabel 310 um das freie Ende der Feder 312 gewickelt. In Figur 5 ist die Feder 312 zwischen dem integrierten Schaltkreis 302 und der Öffnung 334 angeordnet.

Die bevorzugten Ausführungsformen ergeben einen Schutz gegen Beschädigung aufgrund von elektrostatischen Entladungen, die bei der Handhabung der Schaltungsmodule entstehen können. Es kann auf einfacher Weise eine Verbindung mit einem elektronischen Gerät hergestellt werden, indem eine Steckeinrichtung eingesetzt wird, und der Schutz wird automatisch wiederhergestellt, wenn die Steckeinrichtung entfernt wird.

Int. Az.: Case 1539                                    19. Juli 1982   0072492

PATENTANSPRÜCHE


1. Integrierter Schaltungsmodul für ein elektronisches Gerät mit einer Steckeinrichtung für diesen, g e k e n n z e i c h - n e t durch

einen integrierten Schaltkreis (102, 302) mit Kontaktleitungen (106, 306),

ein Behältnis (116, 118) zur Aufnahme des integrierten Schaltkreises, das eine Öffnung zur Aufnahme der Steckeinrichtung für das elektronische Gerät enthält,

ein biegsames Mehrleiterkabel (110, 310) innerhalb des Behältnisses zum Herstellen elektrischer Verbindungen zu dem integrierten Halbkreis über Leiterbahnen (108), die mit den Kontaktleitungen verbunden sind,

eine leitfähige Oberfläche (118, 332) in dem Behältnis zum elektrischen Kurzschließen der Leiterbahnen zum Schutz des integrierten Schaltkreises gegen elektrostatische Entladungen und

eine Federeinrichtung (112, 312) in dem Behältnis, welche die Leiterbahnen gegen die Steckeinrichtung drückt, wenn diese in die Öffnung des Behältnisses eingesetzt ist und welche die Leiterbahnen gegen die leitfähige Fläche drückt, wenn die Steckeinrichtung nicht eingesetzt ist.


2. Schaltungsmodul nach Anspruch 1, dadurch g e k e n n z e i c h - n e t , daß die Federeinrichtung eine Metallfeder (112, 312) mit einer Vielzahl von Zinken (114) enthält.


3. Schaltungsmodul nach Anspruch 1 oder 2, dadurch g e k e n n - z e i c h n e t , daß die integrierte Schaltung (102, 302) ein Festwertspeicher ist.


4. Schaltungsmodul nach Anspruch 1 oder 2, dadurch g e k e n n - z e i c h n e t , daß der integrierte Schaltkreis (102, 302) ein Speicher mit wahlfreiem Zugriff ist.

FIG          1

118

114

112

110

108

106

106          102

116          122

122          120

FIG          2

230

230

226

224

228

FIG 3b

FIG 3a

2/3

0072492

3/3

FIG 4

FIG 5